(19) Europäisches Patentamt

European Patent Office

Office européen des brevets

(11) **EP 1 011 143 B1**

(12) **FASCICULE DE BREVET EUROPEEN**

(45) Date de publication et mention
de la délivrance du brevet:
**15.03.2006 Bulletin 2006/11**

(51) Int Cl.:
*H01L 27/06* (2006.01)      *H04B 1/28* (2006.01)

(21) Numéro de dépôt: **99403173.0**

(22) Date de dépôt: **16.12.1999**

(54) **Dispositif semi-conducteur avec substrat du type BiCMOS à découplage de bruit**

Halbleitervorrichtung mit Substrat vom BiCMOS Typ und Rauschentkopplung

Semiconductor device with BiCMOS type substrate having noise decoupling

(84) Etats contractants désignés:
**DE FR GB IT**

(30) Priorité: **17.12.1998 FR 9815941**

(43) Date de publication de la demande:
**21.06.2000 Bulletin 2000/25**

(73) Titulaire: **STMicroelectronics S.A.**
**92120 Montrouge (FR)**

(72) Inventeur: **Belot, Didier**
**38410 Rives (FR)**

(74) Mandataire: **Casalonga, Axel**
**BUREAU D.A. CASALONGA - JOSSE**
**Paul-Heyse-Strasse 33**
**80336 München (DE)**

(56) Documents cités:
**WO-A-96/37041          US-A- 5 734 976**

- **COPELAND M A: "VLSI FOR ANALOG/DIGITAL COMMUNICATIONS" IEEE COMMUNICATIONS MAGAZINE, vol. 29, no. 5, 1 mai 1991 (1991-05-01), pages 25-30, XP000231082 ISSN: 0163-6804**
- **BURGHARTZ J N ET AL: "INTEGRATED RF AND MICROWAVE COMPONENTS IN BICMOS TECHNOLOGY" IEEE TRANSACTIONS ON ELECTRON DEVICES, vol. 43, no. 9, 1 septembre 1996 (1996-09-01), pages 1559-1570, XP000636271 ISSN: 0018-9383**

EP 1 011 143 B1

## Description

L'invention concerne les dispositifs semi-conducteurs, et plus particulièrement le découplage entre un émetteur de bruit et un récepteur sensible au bruit réalisés à l'intérieur d'un circuit intégré sur un substrat adapté à une technologie BiCMOS (technologie bipolaire CMOS, c'est-à-dire alliant des transistors bipolaires et des transistors complémentaires à effet de champ à grilles isolées).

US 5 734 976 A décrit un circuit intégré réalisé en technologie BICHOS.

Le bruit de couplage à l'intérieur d'un circuit intégré provient essentiellement de deux sources, à savoir le couplage électromagnétique dû au boîtier et aux lignes métalliques du circuit et le couplage électrique dû au substrat.

La présente invention vise plus particulièrement à résoudre le problème du bruit de couplage électrique dû au substrat.

Plus précisément, lorsqu'un émetteur de bruit injecte des charges dans le substrat, celles-ci se répartissent de façon uniforme et peuvent alors être captées par un récepteur dont le fonctionnement peut être perturbé si celui-ci est sensible à ce bruit électrique.

A titre indicatif, un émetteur de bruit, au sens de la présente invention, peut être par exemple un transistor fort signal injectant des charges dans le substrat, charges captées par exemple par un transistor faible signal qui se comporte alors comme un récepteur sensible au bruit.

L'invention s'applique avantageusement mais non limitativement au domaine des téléphones mobiles. Fonctionnellement, un téléphone mobile comporte, après un étage de réception radio-fréquence, un amplificateur faible bruit à transistors destiné à traiter des signaux de très faible puissance, typiquement de l'ordre de 1 nanowatt à 100 nanowatt. Cet amplificateur faible bruit est suivi d'un mélangeur destiné à effectuer une transposition de fréquence à partir d'un signal issu d'un oscillateur commandé en tension associé à une boucle à verrouillage de phase recevant un signal issu d'un oscillateur local et comportant un diviseur de fréquence.

L'oscillateur commandé en tension traite par exemple des signaux de l'ordre de 100 mVolts, tandis que la boucle à verrouillage de phase traite par exemple des signaux de l'ordre de 200 mVolts et comporte notamment pour la partie numérique des transistors CMOS alimentés sous 3 volts. Ces signaux ont typiquement une puissance de l'ordre du watt, ce qui est une forte puissance par rapport à la puissance des signaux traités par l'amplificateur faible bruit. Il en résulte donc dans le substrat un bruit analogique haute fréquence lié à l'oscillateur commandé en tension ainsi qu'un bruit numérique large bande lié à la boucle à verrouillage de phase. L'ensemble de ces perturbations crée un bruit blanc dont la puissance en décibels est de nature à perturber l'amplificateur faible bruit, si l'ensemble de ces composants est réalisé au sein d'un même circuit intégré.

Une solution actuellement envisagée pour remédier à cet inconvénient consiste à réaliser l'amplificateur faible bruit, l'oscillateur commandé en tension et la boucle à verrouillage de phase ainsi que le mélangeur sur des circuits intégrés distincts. A titre indicatif, l'amplificateur faible bruit et l'oscillateur commandé en tension peuvent être réalisés sur deux circuits distincts en substrat d'arséniure de gallium, tandis que la boucle à verrouillage de phase et le mélangeur peuvent être réalisés sur un circuit intégré de silicium et plus particulièrement adapté à une technologie BiCMOS.

Or, ceci conduit à augmenter la surface du dispositif global ainsi que son coût.

L'invention vise à apporter une solution plus satisfaisante à ce problème et propose d'une façon générale, de réaliser au sein d'un même circuit intégré un émetteur de bruit et un récepteur sensible au bruit tout en assurant un découplage entre l'émetteur et le récepteur. En d'autres termes, l'invention vise à éliminer le bruit de couplage se propageant à l'intérieur du substrat du circuit intégré.

L'invention propose donc un dispositif semi-conducteur comprenant dans un enrobage de résine, un circuit intégré possédant des plots de connexion reliés à des pattes métalliques par des fils de liaison.

Selon une caractéristique générale de l'invention, le circuit intégré comprend un substrat semi-conducteur comportant une partie inférieure (par exemple dopée P⁻) surmontée d'une couche supérieure plus fortement dopée que la partie inférieure (par exemple dopée P⁺). En d'autres termes, le substrat est ici un substrat particulièrement adapté à une technologie BiCMOS. Le circuit intégré comporte par ailleurs un premier bloc dit "émetteur de bruit", par exemple un transistor fort signal et/ou un oscillateur commandé en tension et/ou une boucle à verrouillage de phase, ainsi qu'un deuxième bloc dit "sensible au bruit", par exemple un transistor faible signal comme ceux associés en particulier à des amplificateurs faible bruit.

Le bloc émetteur et le deuxième bloc ou bloc récepteur sont réalisés dans la partie supérieure du substrat. Le terme "bloc" doit être compris dans un sens très général au sens de la présente invention. Il peut s'agir d'un simple transistor, mais également d'un ou de plusieurs blocs fonctionnels d'un composant réalisé au sein du circuit intégré.

Le circuit intégré comporte par ailleurs des moyens de découplage disposés au voisinage du deuxième bloc (bloc récepteur) et comportant au moins un circuit de découplage relié à la partie inférieure du substrat ainsi qu'à une patte de connexion, dite patte de connexion de masse, et destinée à être connecté à une masse, ce circuit de découplage possédant une impédance minimale à une fréquence prédéterminée.

En d'autres termes, on réalise dans le substrat un chemin basse impédance (à impédance minimale) à une fréquence prédéterminée, par exemple 950 MHz dans le cas d'une application téléphonie mobile. Ainsi, les charges injectées dans le substrat par l'émetteur de bruit vont, pour ladite fréquence prédéterminée, naturellement emprunter ce chemin d'impédance minimale pour être évacuées vers la masse. On obtient ainsi, pour cette fréquence prédéterminée, une diminution de la puissance du bruit. Si cette fréquence prédéterminée correspond à la fréquence des signaux traités par le récepteur sensible au bruit, on minimise ainsi les perturbations de son fonctionnement.

On a ainsi réalisé un découplage du substrat bande étroite particulièrement adapté à une technologie BiCMOS.

Selon un mode de réalisation de l'invention, le circuit de découplage est un circuit inductif capacitif ayant une fréquence de résonance sensiblement égale à ladite fréquence prédéterminée. Ainsi, à la fréquence de résonance, l'impédance du circuit résonant est minimale.

Dans un boîtier semi-conducteur, la liaison entre les plots de connexion du circuit intégré et l'extérieur se fait par le biais de fils de liaison soudés entre les plots de connexion et les pattes métalliques correspondantes. Et cette liaison, incorporant le fil et la patte de connexion, est généralement inductive.

Aussi, selon un mode de réalisation de l'invention, le circuit de découplage comporte une capacité connectée entre la partie inférieure du substrat et un plot de connexion du circuit intégré, ainsi que des moyens de liaison inductifs comportant la patte de connexion de masse et au moins un fil de liaison connecté entre ledit plot de connexion et ladite connexion de masse.

On connaît, à un pourcentage près, généralement à moins de 5% près, la valeur inductive de la liaison entre le plot de connexion et la masse. Aussi, si l'on choisit la fréquence prédéterminée pour laquelle on souhaite avoir une réjection du bruit en dessous du niveau du signal faible puissance qui ne doit pas être perturbé, on peut en déduire aisément la valeur de la capacité correspondant à cette fréquence de résonance.

On peut réaliser cette capacité par différents moyens, par exemple en réalisant une capacité métal/métal entre deux niveaux de métallisation du circuit intégré. L'une des électrodes de la capacité peut alors être reliée directement à la partie inférieure du substrat par un via, tandis que l'autre électrode peut être reliée également par un via à un niveau de métallisation supérieur formant un plot de connexion.

Ceci étant, il est particulièrement avantageux que la capacité soit formée d'une diode en inverse, réalisée par un caisson semi-conducteur, ménagé dans la couche supérieure du substrat et au contact de la partie inférieure du substrat. Ce caisson semi-conducteur a un type de conductivité opposé à celui de la partie inférieure du substrat. Dans ce cas, ladite patte de connexion de masse est destinée à être reliée à une masse dynamique dont la tension continue est réglable.

L'homme du métier sait en effet que lorsqu'un plan d'alimentation, ayant une valeur de tension fixée, est assez large, la capacité de ce plan par rapport à la masse est très grande et il se produit alors un court-circuit entre ce plan d'alimentation et le plan de masse lorsque la fréquence est élevée. On parle alors de "masse dynamique".

Ce mode de réalisation, qui prévoit l'obtention d'une capacité par réalisation d'une diode montée en inverse, permet un réglage particulièrement précis de la valeur de la capacité. En effet, les dimensions surfaciques (facteur de forme et périmètre) permettent d'obtenir une valeur de capacité très proche de la valeur souhaitée. En outre, le réglage final de la valeur de la fréquence à laquelle l'isolation (découplage) sera maximum, peut être obtenu par modification de la valeur de la tension de la masse dynamique externe (tension de cathode de la diode).

Lorsque la fréquence pour laquelle on souhaite avoir une isolation du bruit est particulièrement élevée, par exemple de l'ordre de 2400 MHz, on peut prévoir que les moyens de liaison inductifs comportent plusieurs fils de liaison connectés entre ledit plot de connexion et ladite patte de connexion de masse, ce qui permet de diminuer la valeur de l'inductance.

Dans certaines applications, les signaux destinés à être traités par le ou les récepteurs sensibles au bruit, peuvent avoir des fréquences différentes. Ainsi, en téléphonie mobile par exemple, on peut être amené à fonctionner sur des réseaux de transmission à 950 MHz, 1800 MHz, 2400 MHz, voire plus. Dans ce cas, l'invention permet de réaliser un découplage large bande du substrat en réalisant les moyens de découplage comprenant plusieurs circuits de découplage ayant respectivement des impédances minimales à différentes fréquences prédéterminées. On pourra ainsi réaliser différentes diodes dont les dimensions surfaciques pourront être différentes en fonction des fréquences d'utilisation souhaitées.

Dans un tel mode de réalisation, il est particulièrement souhaitable que les circuits de découplage soient placés côte à côte entre le bloc émetteur de bruit et le bloc récepteur sensible au bruit. En outre, le circuit de découplage associé à la fréquence la plus basse est celui qui est le plus près du premier bloc (émetteur de bruit), tandis que le circuit de découplage associé à la fréquence la plus haute est celui qui est le plus près du deuxième bloc (sensible au bruit). En d'autres termes, la diode la plus proche de l'émetteur sera celle qui aura une résonance maximum parce qu'elle sera affectée de la résistance substrat la plus faible entre l'émetteur et elle-même. De même, la diode la plus éloignée de l'émetteur sera celle qui aura un coefficient de résonance minimum, parce qu'elle sera affectée de la résistance substrat la plus élevée.

Là encore, un réglage final des valeurs de fréquence auxquelles l'isolation sera maximum peut être obtenu par modification des valeurs de tension continue des masses dynamiques externes auxquelles sont reliées les différentes diodes.

On a vu plus haut que les moyens de découplage doivent être disposés au voisinage du deuxième bloc, et ce de façon à isoler au mieux le récepteur sensible au bruit. En fait, plus les moyens de découplage seront près du récepteur, meilleure sera l'isolation. En pratique, la distance entre les moyens de découplage et le deuxième bloc récepteur est comprise entre quelques microns (liés à la technologie de fabrication) et quelque dizaines de microns (par exemple 50 microns). Ceci étant, l'homme du métier saura aisément ajuster cette distance en fonction des applications et de la réjection de bruit minimale acceptable.

En pratique, le premier bloc (émetteur de bruit) est réalisé dans une première zone de couche supérieure du substrat et le deuxième bloc et les moyens de découplage sont réalisés dans une deuxième zone de la couche supérieure du substrat. Il est alors paticulièrement avantageux que les deux zones soient mutuellement séparées par une barrière semi-conductrice plus fortement dopée que la couche supérieure du substrat, cette barrière semi-conductrice étant reliée à la masse. Une telle isolation permet, en combinaison avec l'implantation des moyens de découplage précédemment mentionnés, d'obtenir dès les basses fréquences, une bonne réjection de bruit.

D'autres avantages et caractéristiques de l'invention apparaîtront à l'examen de la description détaillée de modes de réalisation, nullement limitatifs, et des dessins annexés, sur lesquels :

- la figure 1 est un synoptique schématique de blocs fonctionnels incorporés au sein d'un circuit intégré selon l'invention et correspondant à une application de téléphonie mobile;
- la figure 2 illustre schématiquement la disposition des différents blocs de la figure 1 au sein du substrat du circuit intégré;
- la figure 3 est une coupe selon la ligne III-III de la figure 2;
- la figure 4 illustre très schématiquement les moyens de liaison inductifs des moyens de découplage selon l'invention;
- la figure 5 illustre schématiquement la réjection de bruit obtenu par le dispositif selon l'invention; et
- la figure 6 illustre partiellement et très schématiquement une autre variante du dispositif selon l'invention.

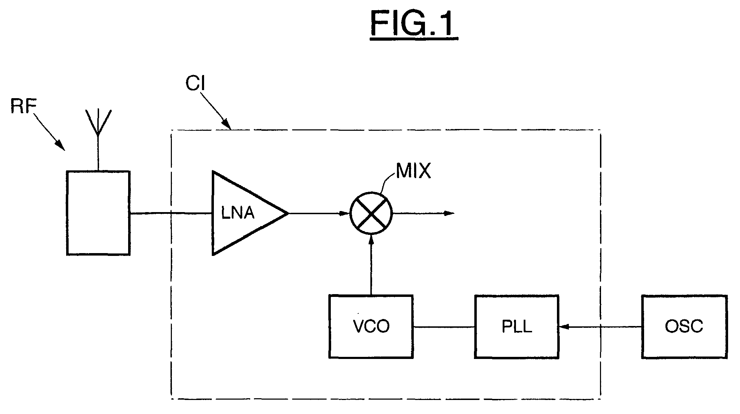

Sur la figure 1, la référence CI désigne un circuit intégré au sein duquel sont réalisés différents éléments d'un étage de réception d'un téléphone mobile par exemple. Plus précisément, ce circuit intégré comporte un amplificateur faible bruit LNA recevant d'une tête de réception radio-fréquence RF, des signaux faible puissance, typiquement de 1 nW à 1 μW, et ayant une fréquence dans le cas particulier qui va être décrit, de 950 MHz si le téléphone mobile est réglé sur un tel réseau de transmission. Ceci étant, comme on le verra plus en détail ci-après, d'autres fréquences peuvent être envisagées, typiquement 1800 MHz, 2400 MHz ou 5200 MHz. Les signaux issus de l'amplificateur faible bruit LNA sont mélangés dans un mélangeur MIX recevant par ailleurs le signal de sortie d'un oscillateur commandé en tension VCO délivrant un signal centré sur la fréquence d'entrée (par exemple 950 MHz) associé à une boucle à verrouillage de phase PLL comportant généralement un diviseur de fréquence numérique. Un oscillateur local OSC, par exemple un quartz, délivre à la boucle à verrouillage de phase un signal de fréquence de référence, typiquement 26 MHz. Dans le cas présent, la fréquence du signal de sortie du mélangeur est voisine de 0 MHz. L'oscillateur VCO induit ici un bruit centré autour de 950 MHz, tandis que la boucle à verrouillage de phase induit un bruit de plus large bande.

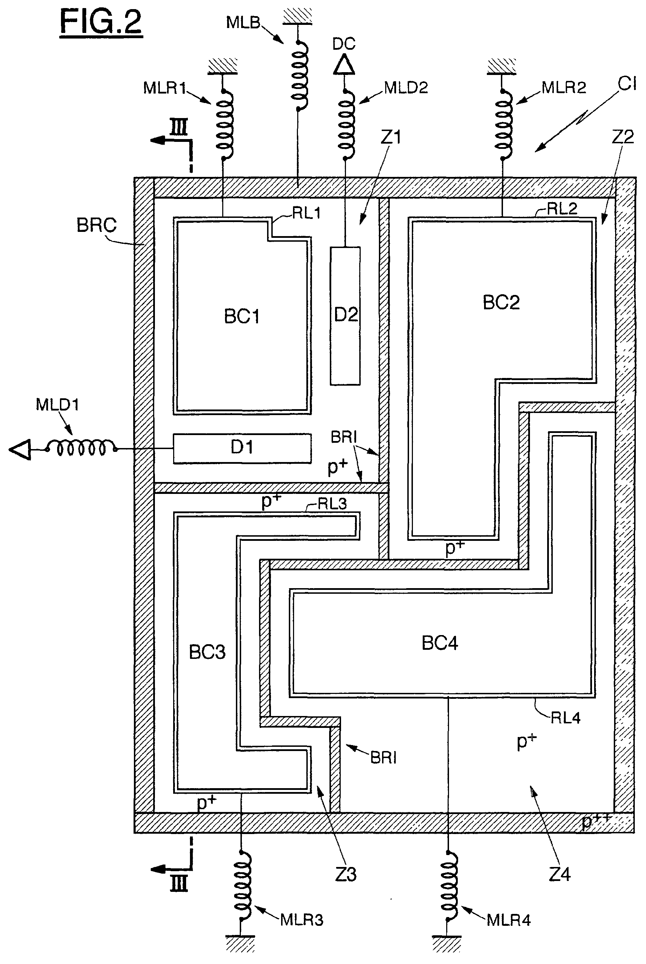

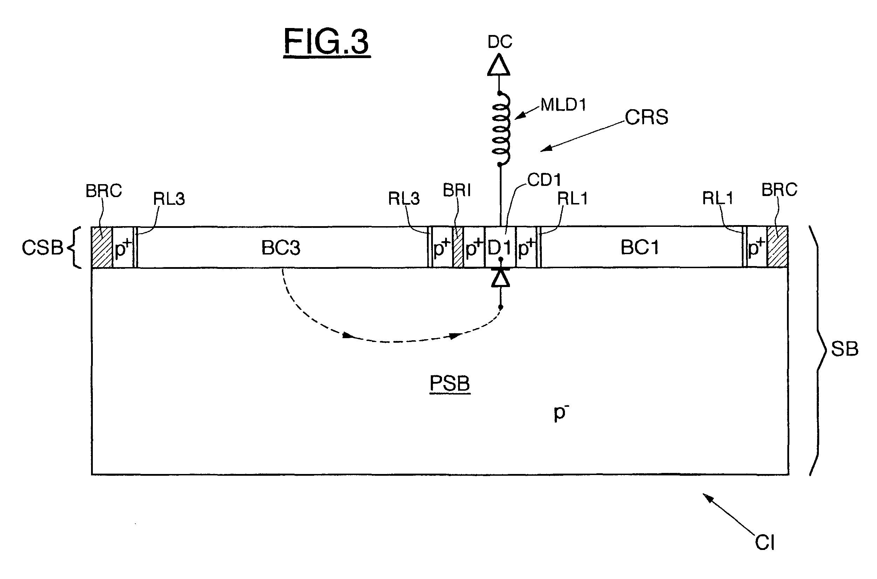

Sur les figures 2 et 3, les références BC1, BC2, BC3 et BC4 désignent respectivement les blocs de substrat incorporant par exemple respectivement l'amplificateur LNA, le mélangeur MIX, l'oscillateur commandé en tension VCO et la boucle à verrouillage de phase PLL.

Ceci étant, d'une façon plus générale, on considèrera en se référant à ces figures 2 et 3, que le bloc BC1 incorpore un récepteur sensible au bruit, tandis que les blocs BC3, BC2 et BC4 sont de nature à émettre du bruit, par exemple un bruit blanc.

Le substrat SB au sein duquel est réalisé le circuit intégré CI, est un substrat utilisable dans un process BiCMOS. Il comporte à cet égard par exemple une partie inférieure faiblement dopée de type P (dopage P⁻ ; typiquement $10^{14}$ à $10^{15}$ atomes de dopants cm$^{-3}$, résistivité 15 Ohms/cm) ayant une épaisseur typiquement de l'ordre de 350 microns. La face arrière du substrat est généralement reliée à la masse. En partie avant, le substrat SB comporte une couche supérieure CSB plus fortement dopée que la partie inférieure PSB. Cette couche CSB, également de conductivité P, présente ainsi typiquement un dopage P⁺ (par exemple $10^{18}$ atomes de dopants cm$^{-3}$) avec une résistivité de l'ordre de 0,2 Ohms/cm. L'épaisseur de cette couche supérieure est typiquement de l'ordre de 3 microns. L'homme du métier sait que cette couche supérieure, permet notamment d'éviter un phénomène d'auto-échauffement des transistors à effet de champ (phénomène de Latch up).

Les zones Z1-Z4 du circuit intégré, au sein desquelles sont réalisés les blocs BC1-BC4, sont mutuellement séparées par une barrière semi-conductrice formée d'une barrière périphérique BRC et de barrières internes BRI. La barrière BRC et les barrières BRI sont en fait des zones semi-conductrices de même type de conductivité que celui de la couche supérieure CSB, mais plus fortement dopées que cette couche CSB. Le dopage de cette barrière d'isolation est ainsi un dopage P⁺⁺ (par exemple $10^{20}$ at. cm$^{-3}$).

L'ensemble de cette barrière semi-conductrice d'isolation est reliée à un plan de masse externe par des moyens de liaison MLB. On reviendra plus en détail ci-après sur la fonction de cette barrière d'isolation.

Par ailleurs, chaque bloc semi-conducteur BCi est entouré d'un anneau semi-conducteur local RLi également dopé P$^{++}$.

L'homme du métier sait que la fonction d'un tel anneau local consiste notamment à créer une équipotentielle de substrat autour du bloc semi-conducteur de façon notamment à éviter tout risque de décalage de valeur des tensions de seuil des transistors MOS incorporés dans ledit bloc. L'invention prévoit également ici de relier de façon indépendante, par des moyens de liaison MLRi, chaque anneau local RLi à la masse.

Par ailleurs, on réalise au sein de la zone Z1 du circuit intégré, au voisinage du bloc BC1, une diode D1 disposée entre le bloc BC3 et le bloc BC1, ainsi qu'une diode D2 disposée également au voisinage du bloc BC1 entre le bloc BC2 et le bloc BC1. Les diodes D1 et D2, toutes les deux reliées à une masse dynamique DC par l'intermédiaire de moyens de liaison inductifs MLD1 et MLD2, forment deux circuits de découplage destinés à isoler le bloc BC1, du bruit généré par le bloc BC3, mais également généré par les blocs BC2 et BC4.

Chaque diode (seule la diode D1 est représentée sur la figure 3) est en fait une diode dont la cathode est reliée à la masse dynamique DC et dont l'anode est reliée à la partie inférieure du substrat PSB. En pratique, cette diode peut être réalisée par un caisson CD 1, de type de conductivité opposé à celui de la partie inférieure du substrat (en l'espèce un caisson N) obtenu par épitaxie ou implantation. La jonction PN de la diode se situe donc à l'interface entre la partie inférieure PSB du substrat et la région dopée N. Cette diode forme une capacité qui réalise, avec les moyens de liaison inductifs MLD associés, un circuit de découplage résonant CRS dont l'impédance sera minimale à la fréquence de résonance. L'impédance du circuit de découplage est pour une pulsation ω donnée, égale à

$$R + jL\omega + \frac{1}{jC\omega}$$

où R désigne la résistance du substrat entre l'émetteur et le caisson CD 1. A la fréquence de résonance, l'impédance est minimale et vaut R. Si l'on ajuste la fréquence de résonance du circuit de découplage à la fréquence des signaux reçus par le bloc BC1, on crée alors, pour cette fréquence, un chemin d'impédance minimal (illustré schématiquement en tiretés sur la figure 3) par lequel les charges générées à cette fréquence dans la partie inférieure du substrat par les blocs émetteurs de bruit BC3, BC4 et BC2, seront évacuées vers la masse.

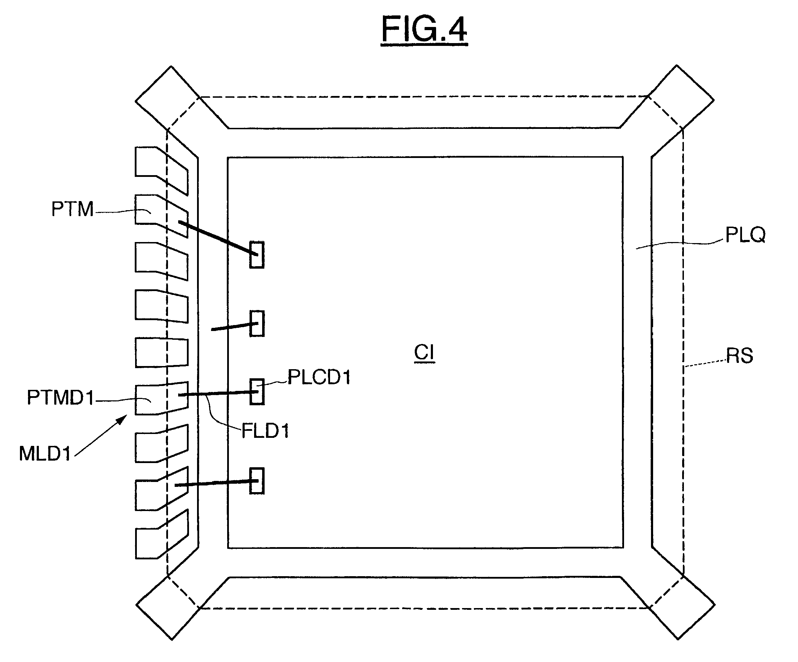

Comme on le voit de façon très schématique sur la figure 4, un circuit intégré repose de façon classique sur une plaque centrale PLQ d'une grille de connexion comportant par ailleurs des pattes de connexion métalliques PTM. L'ensemble est maintenu dans un enrobage de résine RS. Sur la surface du circuit intégré sont ménagés des plots de connexion reliés par des vias (trous d'interconnexion métalliques) aux différents composants actifs du circuit intégré. Ces différents plots de connexion peuvent être soit connectés sur la plaque centrale PLQ, soit directement aux pattes métalliques PTM, par des fils de liaison soudés. Les fils de liaison et les pattes de connexion métalliques associées forment des moyens de liaison inductifs dont la valeur de l'inductance peut être connue à quelques pourcents près. A titre indicatif, la valeur inductive d'un fil de liaison peut être typiquement de l'ordre de 3 nanoHenry, tandis que la valeur inductive des pattes de connexion métalliques est de l'ordre de 2 nanoHenry.

Si co désigne la pulsation associée à la fréquence F de travail ($\omega = 2\pi F$), la capacité C est alors obtenue par la formule (1) :

$$C = \frac{1}{L\omega^2} \qquad (1)$$

En pratique, on détermine de façon connue en soi la taille du caisson et son facteur de forme, de façon à obtenir ladite valeur de la capacité. Puis, on procède à un réglage fin de la fréquence de résonance du circuit résonant ainsi obtenu, c'est-à-dire un réglage fin de la fréquence de travail pour laquelle on souhaite avoir une réjection du bruit, en ajustant la valeur de la tension DC alimentant la patte de connexion PTMD 1 reliée au plot de connexion PLCD1, lui-même relié à la diode D1.

On procède de la même manière pour la diode D2.

Les diodes D1 et D2 doivent être placées au voisinage du bloc BC1 sensible au bruit. Plus ces diodes sont proches du bloc BC1 et meilleure sera l'isolation. Ceci étant, en pratique, il a été constaté qu'une distance comprise entre quelques microns et quelques dizaines de microns donnait des résultats satisfaisants.

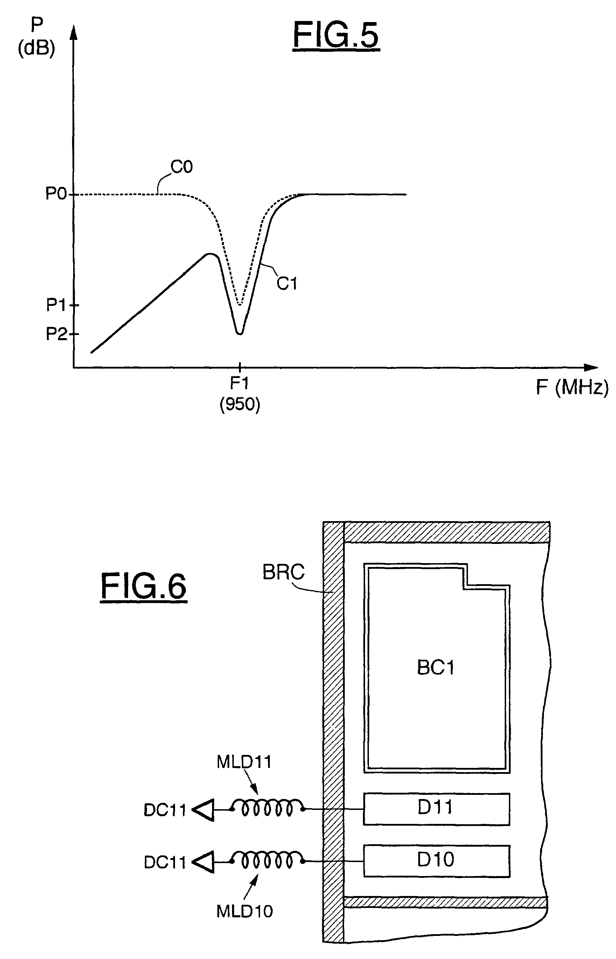

La réjection de bruit est illustrée sur la figure 5. On suppose que le ou les blocs émetteurs de bruit créent dans le substrat un bruit blanc ayant un niveau de puissance P0. On suppose également que la fréquence des signaux reçus et traités par le bloc BC1 est la fréquence F1 (par exemple 950 MHz). Les diodes D1 et D2 ont donc été dimensionnées de façon à obtenir un circuit résonant dont la fréquence de résonance correspond à la fréquence F1. En l'absence des barrières isolantes BRC et BRI, on obtiendrait alors la courbe CO sur la figure 5, c'est-à-dire une diminution de la puissance du bruit à un niveau P1 qui se situe en dessous du niveau de sensibilité du bloc BC1 (en l'espèce l'amplificateur faible niveau). La présence des barrières isolantes BRC et BRI, reliées à la masse externe, ainsi que la présence des anneaux locaux reliés indépendamment à la masse, permet d'obtenir la courbe C1 qui se traduit par une bonne réjection déjà aux basses fréquences et qui permet d'obtenir pour la fréquence F1, un niveau de bruit P2 encore inférieur au niveau P1.

Lorsque le bloc sensible au bruit doit traiter des signaux qui peuvent avoir des fréquences de travail différentes, par exemple un téléphone mobile qui peut se connecter sur un réseau à 950 MHz ou bien à 1800 MHz ou 2400 MHz ou encore 5200 MHz, l'invention permet d'effectuer un découplage large bande du substrat. Plus précisément, comme illustré sur la figure 6, les moyens de découplage se composent alors d'autant de circuits résonants qu'il y a de fréquences de travail. On n'a représenté à des fins de simplification que deux diodes D10 et D11 sur la figure 6, correspondant respectivement aux fréquences 950 MHz et 1800 MHz. D'une façon générale, la distance entre la diode la plus proche du bloc BC 1 sera comprise entre quelques microns et quelques dizaines de microns, et la diode associée à la fréquence de travail la plus faible sera située la plus loin du bloc BC1, tandis que la diode associée à la fréquence de travail la plus élevée sera disposée la plus proche du bloc BC1. On obtient ainsi un ensemble de fréquences pour lesquelles l'isolation est maximum.

L'invention permet ainsi, en utilisant des diodes de tailles spécifiques et en les plaçant entre un ou des blocs qui émettent un bruit blanc et un autre bloc qui est sensible au bruit sur une bande de fréquences, d'améliorer sensiblement l'isolation tout en utilisant un boîtier faible coût.

## Revendications

**1.** Dispositif semi-conducteur comprenant dans un enrobage de résine (RS) un circuit intégré (CI) possédant des plots de connexion reliés à des pattes métalliques par des fils de liaison, ce circuit intégré (CI) comportent un substrat semi-conducteur (SB) comportant une partie inférieure (PSB) surmontée d'une couche supérieure (CSB) plus fortement dopée que la partie inférieure, ainsi qu'un premier bloc (BC3) et un deuxième bloc (BC1) réalisés dans la partie supérieure du substrat, **caractérisé par** des moyens de découplage disposés au voisinage du deuxième bloc (BC1) et comportant au moins un circuit de découplage (CRS) relié à la partie inférieure du substrat (PSB) et à une patte de connexion de masse (PTMD1) destinée à être connectée à une masse, et possédant une impédance minimale à une fréquence prédéterminée.

**2.** Dispositif selon la revendication 1, **caractérisé par le fait que** le circuit de découplage (CRS) comporte un circuit résonant inductif capacitif ayant une fréquence de résonance sensiblement égale à ladite fréquence prédéterminée.

**3.** Dispositif selon la revendication 2, **caractérisé par le fait que** le circuit de découplage (CRS) comporte une capacité (C) connectée entre la partie inférieure du substrat et un plot de connexion (PLCD1) du circuit intégré, ainsi que des moyens de liaison inductifs (MLD1) comportant ladite patte de connexion de masse (PTMD1) et au moins un fil de liaison (FLD1) connecté entre ledit plot de connexion et ladite patte de connexion de masse.

**4.** Dispositif selon la revendication 3, **caractérisé par le fait que** la capacité est formée d'une diode (D1) en inverse réalisée par un caisson semi-conducteur (CD1) ménagé dans la couche supérieure du substrat et au contact de la partie inférieure du substrat, ce caisson semi-conducteur (CD1) ayant un type de conductivité opposé à celui de la partie inférieure du substrat, **par le fait que** ladite patte de connexion de masse est destinée à être reliée à une masse dynamique dont la tension continue (DC) est réglable.

**5.** Dispositif selon la revendication 4, **caractérisé par le fait que** les dimensions surfaciques du caisson (CD1) définissent la valeur de la capacité.

**6.** Dispositif selon la revendication 3, 4 ou 5, **caractérisé par le fait que** les moyens de liaison inductifs (MLD1) comportent plusieurs fils de liaison connectés entre ledit plot de connexion et ladite patte de connexion de masse.

**7.** Dispositif selon l'une des revendications précédentes, **caractérisé par le fait que** les moyens de découplage comprennent plusieurs circuits de découplage (D10, D11) ayant respectivement des impédances minimales à différentes fréquences prédéterminées.

**8.** Dispositif selon la revendication 7, **caractérisé par le fait que** les circuits de découplage (D10, D11) sont placés côte à côte entre le premier bloc et le deuxième bloc, le circuit de découplage associé à la fréquence la plus basse étant celui qui est le plus près du premier bloc tandis que le circuit de découplage associé à la fréquence la plus haute est celui qui est le plus près du deuxième bloc.

**9.** Dispositif selon l'une des revendications précédentes, **caractérisé par le fait que** la distance entre les moyens de découplage (CRS) et le deuxième bloc (BC1) est comprise entre quelques microns et quelques dizaines de microns.

**10.** Dispositif selon l'une des revendications précédentes, **caractérisé par le fait que** le premier bloc (BC3) est réalisé dans une première zone (Z3) de la couche supérieure du substrat, **par le fait que** le deuxième bloc (BC1) et les moyens de découplage (CRS) sont réalisés dans une deuxième zone (Z1) de la couche supérieure du substrat, et **par le fait que** les deux zones sont mutuellement séparées par une barrière semi-conductrice (BRC, BRI) plus fortement dopée que la couche supérieure du substrat, cette barrière semi-conductrice étant reliée à la masse.

**Patentansprüche**

1. Halbleitervorrichtung, die in einer Harzverkapselung (RS) eine integrierte Schaltung (CI) mit Anschlußpunkten aufweist, die über Verbindungsdrähte mit Metallflecken verbunden sind, wobei die integrierte Schaltung (CI)
ein Halbleitersubstrat (SB), das einen unteren Teil (PSB) aufweist, über welchem eine obere Schicht (CSB) angeordnet ist, die stärker dotiert ist als der untere Teil,
sowie einen ersten Block (BC3) und einen zweiten Block (BC1), die in dem oberen Teil des Substrats realisiert sind,
aufweist, **gekennzeichnet durch**
Entkopplungseinrichtungen, die in Nachbarschaft des zweiten Blocks (BC1) angeordnet sind und mindestens eine Entkopplungsschaltung (CRS) aufweisen, welche mit dem unteren Teil des Substrats (PSB) und einem Erdungsanschlußfleck (PTMD1) verbunden ist, der vorgesehen ist, um an Erde angeschlossen zu werden, und welche bei einer vorgegeben Frequenz eine minimale Impedanz besitzt.

2. Vorrichtung nach Anspruch 1, **dadurch gekennzeichnet, daß** die Entkopplungsschaltung (CRS) eine induktive kapazitive Resonanzschaltung aufweist, die eine Resonanzfrequenz hat, die im wesentlichen gleich der vorgegebenen Frequenz ist.

3. Vorrichtung nach Anspruch 2, **dadurch gekennzeichnet, daß** die Entkopplungsschaltung (CRS) eine Kapazität (C) aufweist, die zwischen dem unteren Teil des Substrats und einem Anschlußpunkt (PLCD1) der integrierten Schaltung angeordnet ist, sowie induktive Verbindungseinrichtungen (MLD1) aufweist, die den Erdungsanschlußfleck (PTMD1) und mindestens einen Verbindungsdraht (FLD1) aufweisen, der den Anschlußpunkt und den Erdungsanschlußfleck verbindet.

4. Vorrichtung nach Anspruch 3, **dadurch gekennzeichnet, daß** die Kapazität aus einer Diode (D1) in Sperrichtung besteht, die durch einen Halbleiterkasten (CD1) realisiert ist, das in der oberen Schicht des Substrats angeordnet ist und in Kontakt mit dem unteren Teil des Substrats ist, wobei dieser Halbleiterkasten (CD1) einen Leitungstyp hat, der entgegengesetzt zu demjenigen des unteren Teils des Substrats ist, **dadurch,** daß der Erdungsanschlußfleck vorgesehen ist, um mit einer dynamischen Erde verbunden zu werden, deren Gleichspannung (DC) regelbar ist.

5. Vorrichtung nach Anspruch 4, **dadurch gekennzeichnet, daß** die oberflächenbezogenen Abmessungen des Kastens (CD1) den Wert der Kapazität definieren.

6. Vorrichtung nach Anspruch 3, 4 oder 5, **dadurch gekennzeichnet, daß** die induktiven Verbindungseinrichtungen (MLD1) mehrere Verbindungsdrähte aufweisen, die den Anschlußpunkt und den Erdungsanschlußfleck verbinden.

7. Vorrichtung nach einem der vorstehenden Ansprüche, **dadurch gekennzeichnet, daß** die Entkopplungseinrichtungen mehrere Entkopplungsschaltungen (D10, D11) aufweisen, die jeweils bei unterschiedlichen vorgegebenen Frequenzen minimale Impedanzen haben.

8. Vorrichtung nach Anspruch 7, **dadurch gekennzeichnet, daß** die Entkopplungsschaltungen (D10,D11) nebeneinander zwischen dem ersten Block und dem zweiten Block angeordnet sind, wobei die der tiefsten Frequenz zugeordnete Entkopplungsschaltung diejenige ist, die dem ersten Block am nächsten angeordnet ist, während die der höchsten Frequenz zugeordnete Entkopplungsschaltung diejenige ist, die dem zweiten Block am nächsten angeordnet ist.

9. Vorrichtung nach einem der vorstehenden Ansprüche, **dadurch gekennzeichnet, daß** der Abstand zwischen den Entkopplungseinrichtungen (CRS) und dem zweiten Block (BC1) zwischen einigen Mikrometer und einigen zehn Mikrometer beträgt.

10. Vorrichtung nach einem der vorstehenden Ansprüche, **dadurch gekennzeichnet, daß** der erste Block (BC3) in einer ersten Zone (Z3) der oberen Schicht des Substrats realisiert ist, **dadurch,** daß der zweite Block (BC1) und die Entkopplungseinrichtungen (CRS) in einer zweiten Zone (Z1) der oberen Schicht des Substrats realisiert sind und **dadurch,** daß die zwei Zonen durch eine Halbleiterbarriere (BRC, BRI), die stärker dotiert ist als die obere Schicht des Substrats, voneinander getrennt sind, wobei die Halbleiterbarriere an Erde angeschlossen ist.

**Claims**

1. Semiconductor device comprising, in resin encapsulation (RS), an integrated circuit (CI) possessing connection terminals connected to metal pads by connecting wires, this integrated circuit (CI) having a semiconductor substrate (SB) having a lower part (PSB) on top of which there is an upper layer (CSB) more heavily doped than the lower part, as well as a first block (BC3) and a second block (BC1) which are produced in the upper part of the substrate, **characterized by** decoupling means which are arranged in the vicinity of the second block (BC1) and include at least one decoupling circuit (CRS) connected to the lower part of the substrate (PSB) and to an earth connection pad (PTMD1) intended to be connected to an earth, and having a minimum impedance at a predetermined frequency.

2. Device according to Claim 1, **characterized in that** the decoupling circuit (CRS) has an inductive-capacitive resonant circuit having a resonant frequency substantially equal to the said predetermined frequency.

3. Device according to Claim 2, **characterized in that** the decoupling circuit (CRS) includes a capacitor (C) connected between the lower part of the substrate and a connection terminal (PLCD1) of the integrated circuit, as well as inductive connecting means (MLD1) including the said earth connection pad (PTMD1) and at least one connecting wire (FLDL) connected between the said connection terminal and the said earth connection pad.

4. Device according to Claim 3, **characterized in that** the capacitor is formed by a reverse-biased diode (D1), produced by a semiconductor well (CD1) formed in the upper layer of the substrate and in contact with the lower part of the substrate, this semiconductor well (CD1) having an opposite type of conductivity to that of the lower part of the substrate, and **in that** the said earth connection pad is intended to be connected to a dynamic earth whose DC voltage (DC) is adjustable.

5. Device according to Claim 4, **characterized in that** the surface dimensions of the well (CD1) define the value of the capacitance.

6. Device according to Claim 3, 4 or 5, **characterized in that** the inductive connecting means (MLD1) include a plurality of connecting wires connected between the said connection terminal and the said earth connection pad.

7. Device according to one of the preceding claims, **characterized in that** the decoupling means comprise a plurality of decoupling circuits (D10, D11) respectively having minimum impedances at different predetermined frequencies.

8. Device according to Claim 7, **characterized in that** the decoupling circuits (D10, D11) are placed side by side between the first block and the second block, the decoupling circuit associated with the lowest frequency being the one which is closest to the first block, while the decoupling circuit associated with the highest frequency is the one which is closest to the second block.

9. Device according to one of the preceding claims, **characterized in that** the distance between the decoupling means (CRS) and the second block (BC1) is between a few microns and a few tens of microns.

10. Device according to one of the preceding claims, **characterized in that** the first block (BC3) is produced in a first zone (Z3) of the upper layer of the substrate, **in that** the second block (BC1) and the decoupling means (CRS) are produced in a second zone (Z1) of the upper layer of the substrate, and **in that** the two zones are mutually separated by a semiconductor barrier (BRC, BRI) more heavily doped than the upper layer of the substrate, this semiconductor barrier being earthed.

## FIG.1

# FIG.2

# FIG.3

EP 1 011 143 B1

# FIG.4

EP 1 011 143 B1

## FIG.5

## FIG.6